# EUROPÄISCHE PATENTANMELDUNG

(11) **EP 1 246 242 A1**
(43) Veröffentlichungstag der Anmeldung: **02.10.2002**
(21) Anmeldenummer: 01810302.8
(22) Anmeldetag: 26.03.2001
(51) Int. Cl.: H01L 23/488, H01L 23/051

(54) **Kurzschlussfestes IGBT Modul**

(71) Anmelder: ABB RESEARCH LTD., 8050 Zürich (CH)
(72) Erfinder: Knapp, Wolfgang, 5430 Wettingen (CH); Ovren, Christer, 72243 Västeräs (SE); Schneider, Daniel, 8032 Zürich (CH)
(74) Vertreter: ABB Patent Attorneys

(57) **Zusammenfassung**

Eine elektrisch leitende Schicht (7), welche ein mit dem Material des Halbleiterchips (4) ein Eutektikum bildendes Material enthält und in unmittelbarem Kontakt zu einer oder beiden Hauptelektroden (5, 6) des Halbleiterchips (4) steht, ist als ein Bündel aus geraden und im wesentlichen parallel zueinander angeordneten Drähten ausgebildet.

Diese Schicht ermöglicht im Schadensfall einen stabilen Kurzschluss und dient im Betriebszustand als thermischen Spannungsentlastungspuffer.

## Beschreibung

### Technisches Gebiet

Die vorliegende Erfindung bezieht sich auf das Gebiet der Leistungselektronik. Sie betrifft ein Hochleistungs-Halbleitermodul nach dem Oberbegriff des Patentanspruchs 1.

### Stand der Technik

Es hat sich gezeigt, dass beispielsweise bei druckkontaktierten Thyristoren ein Defekt zu einem Kurzschluss führt. Bei grossen Chipflächen bleibt dieser Kurzschluss über lange Zeit stabil erhalten. Sind in einem Stapel aus seriegeschalteten Thyristoren redundante Thyristoren vorgesehen, so können die restlichen, intakten Thyristoren während der Sperrphase die Spannung aufnehmen und der Stapel bleibt operativ. Defekte Thyristoren können in der Folge anlässlich von geplanten Servicearbeiten ausgetauscht werden.

In einem Thyristor Modul befindet sich der Halbleiter, d.h. das Si, in mechanischem und elektrischem Kontakt zwischen zwei Mo Scheiben. Si hat einen Schmelzpunkt von 1420°C, derjenige von Mo liegt höher und die intermetallischen Verbindungen aus Si und Mo haben ebenfalls einen höheren Schmelzpunkt. Im Defektfall schmilzt daher als erstes das Si lokal auf und es bildet sich unter Stromfluss ein leitender Kanal aus geschmolzenem Si über die ganze Dicke des Halbleiters. Diese Defektzone kann sich ausbreiten und/oder verschieben, wird aber stets nur einen kleinen Teil der Chipfläche betreffen. In hermetisch abgeschlossenen Gehäusen oxidiert das geschmolzene Si nicht, sondern reagiert mit Mo zu einer Art Pulver. Dieser Prozess dauert an bis alles Si aufgebraucht ist und kann sich möglicherweise über Jahre erstrecken.

Im Gegensatz zu den Thyristor Halbleiterbauelementen werden IGBT Chips nicht als grossflächige Einheiten produziert und in den IGBT Modulen sind normalerweise mehrere kleinflächige Einzelchips getrennt nebeneinander angeordnet.

Es hat sich nun gezeigt, dass für druckkontaktierte IGBT Module keine stabilen Kurzschlüsse der oben geschilderten Art erwartet werden können. Dies in erster Linie wegen der reduzierten Fläche der Einzelchips bzw. des geringen Siliziumvolumens. Die pseudostabile Phase eines Kurzschlusses dauert in diesem Fall nur wenige Stunden. Zudem sind die Gehäuse oft-mals bewusst nicht hermetisch abgeschlossen, so dass das geschmolzene Silizium mit Sauerstoff reagieren und isolierendes Si0₂ bilden kann. Ohne stabilen Kurzschlusspfad im defekten Chip kann im schlimmsten Schadensfall folgendes passieren. Sind die restlichen Chips eines Moduls inklusive Ansteuerung noch intakt, können sie während der Sperrphase Spannung aufnehmen. Der Strom wird dann durch den defekten Chip gezwungen und kann in diesem bei Spannungen bis zur Durchbruchsspannung der intakten Chips zu einem Plasma mit sehr hoher Leistungsdichte führen. Als Folge davon wird das ganze Modul zerstört.

In EP 989 611 sind aus kleinflächigen Einzelchips aufgebaute Leistungshalbleitermodule beschrieben, bei welchen ein Kurzschluss eines Einzelchips nicht zu einem Totalausfall des Moduls führt. Eine Schicht aus einem geeigneten Material, beispielsweise Ag, ist in unmittelbaren Kontakt zu einer oder beiden Hauptelektroden des Si-Halbleiters gebracht. Das Material dieser Schicht bildet mit Si ein Eutektikum. Im Kurzschlussfall erwärmen sich die ganze Sandwichstruktur, und an der Kontaktfläche zwischen besagter Schicht und dem Si beginnt sich ab Erreichen des Schmelzpunktes des Eutektikums eine leitende Schmelze auszubilden. Diese Zone kann sich anschliessend über die Ganze Dicke des Halbleiters ausdehnen und somit einen metallisch leitenden Kanal formen. Somit wird im Schadensfall ein stabiler Kurzschluss ermöglicht, indem sich ein metallisch leitender Kanal zwischen den Hauptelektroden des betroffenen Si-Halbleiterchips ausbildet. Dieser Kanal ist auf einen Teil der Chipfläche begrenzt, übernimmt jedoch den gesamten Nennstrom und verhindert so eine weitere Erwärmung des restlichen Si. Der Schmelzpunkt der metallisch leitenden Schmelze in diesem Kanal beziehungsweise der entsprechenden festen, silizium- und silberhaltigen Verbindung liegt notwendigerweise tiefer als der Schmelzpunkt von reinem Si.

Durch die grosse Differenz in der Wärmeausdehnung zwischen dem Si des Halbleiters und dem Material besagter Schicht kommt es an der Kontaktfläche zu grossen thermischen Spannungen, wenn sich der Halbleiter mit Temparaturänderungen ausdehnt und zusammenzieht.

Diese thermischen Spannungen bewirken einen beschleunigten Alterungsprozess des Halbleitermoduls, wodurch sich dessen durchschnittliche Lebensdauer reduziert.

Um die thermischen Spannungen nicht zu gross werden zu lassen, müssen in der Wahl des Materials der Schicht Kompromisse zwischen der Kurzschlussfestigkeit und der Lebensdauer des Halbleitermoduls eingegangen werden. Zudem beschränkt sich das Einsatzgebiet auf kleinflächige Halbleiterchips.

Thermische Spannungsentlastung in einer Kupferschicht ist aus US 4 385 310 bekannt. Anstelle einer homogenen Schicht werden gebündelte, parallel angeordnete Drähte verwendet.

### Kurze Darstellung der Erfindung

Die Aufgabe der vorliegenden Erfindung besteht darin, ein kurzschlussfestes Leistungshalbleitermodul gemäss dem Oberbegriff des Patentanspruchs 1 mit verlängerter Lebensdauer zu schaffen. Die Aufgabe wird bei einem Bauelement der oben genannten Art durch die Merkmale des Patentanspruchs 1 gelöst.

Der Kern der Erfindung besteht darin, dass eine Schicht, welche ein mit Si ein Eutektikum bildendes Material enthält und in unmittelbarem Kontakt zu einer oder beiden Hauptelektroden des Si-Halbleiters steht, als ein Bündel aus geraden und im wesentlichen parallel zueinander angeordneten Drähten ausgebildet ist.

Im Kurzschlussfall erwärmen sich die ganze Sandwichstruktur, und an der Kontaktfläche zwischen der erfindungsgemäss strukturierten Schicht und dem Si beginnt sich ab Erreichen des Schmelzpunktes des Eutektikums eine leitende Schmelze auszubilden. Dank der strukturierten Ausbildung fliesst das Material der Schicht schnell und ohne Verspannungen, so dass die Schmelze sich über die Ganze Dicke des Halbleiters ausdehnt und einen metallisch leitenden Kanal formt. Somit wird im Schadensfall ein stabiler Kurzschluss ermöglicht, indem sich ein metallisch leitender Kanal zwischen den Hauptelektroden des betroffenen Si-Halbleiterchips ausbildet.

Diese eine Schicht ermöglicht somit einerseits im Schadensfall einen stabilen Kurzschluss und dient andererseits im Betriebszustand als thermischen Spannungsentlastungspuffer. Und da die Schicht die Funktion als thermischen Spannungsentlastungspuffer dank ihrer Struktur materialunabhängig leistet, kann die Wahl des Materials der Schicht ausschliesslich hinsichtlich einer optimalen Kurzschlussfestigkeit im Schadensfall getroffen werden. Somit kann erst bei der erfindungsgemäss strukturierten Schicht die bestmögliche Kurzschlussfestigkeit gewährt werden.

Im Gegensatz zu der homogenen, mit dem Material des Halbleiterchips ein Eutektikum bildenden Schicht erweitert sich das Einsatzgebiet der erfindungsgemäss strukturierten Schicht auf grossflächige Halbleiterchips.

### Kurze Beschreibung der Zeichnung

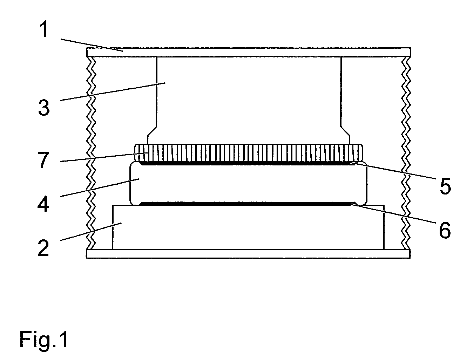

Fig. 1 zeigt einen Querschnitt durch ein Leistungshalbleitermodul nach der Erfindung. Die Darstellung ist nicht massstabgetreu.

### Weg zur Ausführung der Erfindung

In der Fig. 1 ist im Querschnitt ein bevorzugtes Ausführungsbeispiel für ein Hochleistungshalbleitermodul nach der Erfindung gezeigt. In einem Gehäuse 1 ist ein Halbleiterchip 4 angeordnet. Es können auch mehrere Halbleiterchips nebeneinander in einem gemeinsamen Gehäuse angeordnet sein, wobei die Halbleiterchips elektrisch parallelgeschaltet sind und die für hohe Ströme benötigte aktive Halbleiterfläche auf diese Weise als Summe mehrerer Einzelflächen zusammengesetzt ist. Nicht dargestellt ist in der Figur der normalerweise gebondete Gateanschluss zur Ansteuerung des Halbleiterelements.

Der Halbleiterchip 4 umfasst auf der Unter- und Oberseite je eine metallisierte Hauptelektrode 5, 6, welche mit metallischen Kontaktflächen in elektrischem Kontakt stehen. Die Chips sind auf ein leitendes Substrat 2 aufgebracht und direkt über jedem Chip ist ein Kontaktstempel 3 angeordnet.

In einer ersten Ausführungsform wird ein ausreichender elektrischer Kontakt ausschliesslich über Druck erzeugt, welcher auf die Stirnflächen des Gehäuses 1 ausgeübt wird. Dabei drücken die Kontaktstempel 3 auf die zweite Hauptelektrode 6 und kontaktieren so den Chip 4. Diese Ausführungsform kommt also ohne Lot aus. Die erfindungsgemässe Schicht 7 kommt zwischen eine der Hauptelektroden 5,6 und die anschliessende metallische Kontaktfläche zu liegen. Es ist auch denkbar, anschliessend an beide Hauptelektroden je eine erfindungsgemässe Schicht 7 anzubringen.

Die erfindungsgemässe Schicht 7 besteht aus einem Bündel gerader Drähte oder Stränge aus einem Material, welches mit dem Material des Halbleiters ein Eutektikum bildet, eine Verbindung oder Legierung also, deren Schmelzpunkt unterhalb demjenigen des Halbleitermaterials liegt. Die Drähte oder Stränge sind parallel zueinander angeordnet, dicht zusammengepackt und besitzen die gleiche Länge in vertikaler Richtung im Sinne der Figur.

Für einen Si-Halbleiterchip bietet sich als Eutektikumspartner Ag an. Der Schmelzpunkt einer AgSi Legierung mit 11 at% Ag (Eutektischer Punkt) liegt bei 835°C und damit deutlich tiefer als derjenige von reinem Si. Experimente mit Ag haben zu reproduzierbar stabilen Kurzschlüssen geführt mit Stromtragfähigkeiten bis über 1500 A Nennstrom pro Einzelchip (Chipfläche 12x12mm) und über eine Dauer von mehr als 1000h. Aber auch Au, Cu, Mg oder Al sind denkbar.

Im Weiteren sind selbstverständlich auch andere Materialien möglich, insbesondere falls ein anderes Halbleitermaterial gewählt wird. Der Eutektikumspartner muss nicht in reiner Form vorliegen, sondern kann selber Teil einer Verbindung oder Legierung sein, beispielsweise in Form einer AI-Legierung. Vorteilhafterweise liegt der Schmelzpunkt einer solchen Verbindung oder Legierung unterhalb demjenigen des Eutektikums. Der Eutektikumspartner sollte dabei jedoch mindestens 10 Volumenprozente der Verbindung oder Legierung ausmachen.

Dank der strukturierten Beschaffenheit der Schicht muss bei der Wahl des Materials der Schicht keine Rücksicht auf die Wärmeausdehnungseigenschaft genommen werden. Das Material kann allein hinsichtlich einer optimalen Kurzschlussfestigkeit gewählt werden.

Im Allgemeinen ist die Dicke der erfindungsgemässen Schicht 7, und somit die Länge der einzelnen Drähte oder Stränge, grösser als die halbe Dicke des Halbleiters 4 zu wählen. Dünne Metallisierungsschichten genügen nicht für die durchgehende Ausbildung eines leitenden Kanals im Schadensfall.

In einer zweiten, nicht ausschliesslich druckkontaktierten Ausführungsform sind zwischen den Hauptelektroden 5,6 und den metallischen Kontaktflächen zwecks stoffschlüssiger Verbindung Lotschichten vorgesehen. Die Lotschicht kann beispielsweise eine erste Hauptelektrode 5,6 und die zusätzliche, erfindungsgemässe Schicht 7 die gegenüberliegende Hauptelektrode 6,5 kontaktieren. Weiter kann die Lotschicht auch direkt die erfindungsgemässe Schicht 7 kontaktieren, wobei die Gegenseite wahlweise druckkontaktiert oder gelötet ist.

Anstelle von Lotschichten können auch andere Verbindungstechniken wie Drucksintern zum verwendet werden. Ein Verfahren zur Befestigung elektronischer Bauelement auf einem Substrat durch Drucksintern ist beispielsweise in EP 764 978 beschrieben. Dabei wird eine Kontaktfläche des Bauelements und/ oder eine Kontaktfläche des Substrats mit einer Schicht aus einem sinterfähigen Metallpulver beschichtet. Nach der Beschichtung werden Bauelement und Substrat mit ihren einander zugekehrten Kontaktflächen zusammengebracht, mit einem bestimmten Druck zusammengedrückt und in diesem zusammengedrückten Zustand auf eine Sintertemperatur, bei der die Schicht gesintert wird, erwärmt.

Der Eutektikumspartner muss nicht in reiner Form vorliegen, sondern kann selber Teil einer Verbindung oder Legierung sein, beispielsweise in Form eines silberhaltigen Lotes. Vorteilhafterweise liegt der Schmelzpunkt einer solchen Verbindung unterhalb demjenigen des Eutektikums. Der Eutektikumspartner sollte mindestens 10 Volumenprozente der Verbindung oder Legierung ausmachen.

Bei allen vorgängig geschilderten Ausführungsformen passiert im Schadensfall folgendes: Als primäres Schadensereignis tritt ein Kurzschluss auf in einem Einzelchip, worauf der gesamte Nennstrom durch diesen Chip fliesst. Die Sandwichstruktur aus Halbleiterchip 4, Elektroden 5,6 und der erfindungsgemässen Schicht 7 erwärmt sich, bis ab Erreichen des Eutektischen Punktes eine siliziumhaltige Schmelze gebildet wird. Falls die erfindungsgemässe Schicht eine ausreichende Dicke aufweist, kann sich ausgehend von der Kontaktfläche ein leitender Kanal aus Schmelze durch den ganzen Chip ausbilden. Dieser trägt den Strom und verhindert, dass sich die Sandwichstruktur bis zum Schmelzpunkt von reinem Si aufwärmt.

Auf die Art und interne Struktur der Halbleiterchips selbst ist in den bisherigen Erläuterungen nicht eingegangen worden. Sofern das Modul insgesamt ein IGBT Modul darstellt, ist die interne Struktur entsprechend diejenige eines IGBT oder einer Diode, die Erfindung kann aber auch auf andere Halbleiterbauelemente angewendet werden.

### Bezugszeichenliste

- 1: Gehäuse
- 2: Substrat
- 3: Kontaktstempel
- 4: Halbleiterchip
- 5, 6: Hauptelektroden
- 7: Strukturierte Schicht

## Patentansprüche

1. Leistungshalbleitermodul, umfassend in einem Gehäuse (1) ein Substrat (2), einen Kontaktstempel (3) und einen Halbleiterchip (4) mit zwei Hauptelektroden (5, 6), wobei
- die erste Hauptelektrode (5) mit dem Substrat (2) und die zweite Hauptelektrode (6) mit dem Kontaktstempel (3) in elektrischem Kontakt steht,
- zwischen der ersten Hauptelektrode (5) und dem Substrat (2) oder der zweiten Hauptelektrode (6) und dem Kontaktstempel (3) eine elektrisch leitende Schicht (7) vorgesehen ist, und
- die Schicht (7) ein Material enthält, mit welchem zusammen das Material des Halbleiterchips (4) zu einem Eutektikum verschmilzt,
**dadurch gekennzeichnet, dass**
- die Schicht (7) als ein Bündel aus geraden und im wesentlichen parallel zueinander angeordneten Drähten ausgebildet ist.

2. Leistungshalbleitermodul nach Anspruch 1, **dadurch gekennzeichnet, dass**
- das Material des Halbleiterchips (4) Si ist, und
- das Material der Schicht (7) Al, Ag, Au, Cu, oder Mg oder eine Verbindung dieser Elemente enthält.

3. Leistungshalbleitermodul nach Anspruch 2, **dadurch gekennzeichnet, dass**
- der Schmelzpunkt der Verbindung aus Si und dem Material der Schicht (7) unterhalb 900° liegt.
